# EUROPÄISCHE PATENTSCHRIFT

(11) **EP 3 887 782 B1**
(45) Veröffentlichungstag und Bekanntmachung des Hinweises auf die Patenterteilung: **01.01.2025**
(21) Anmeldenummer: 19821253.2
(22) Anmeldetag: 27.11.2019
(51) Int. Cl.: G01J 1/46, G01J 1/04, G01J 1/16, G01R 31/26, G01J 1/42, G01J 1/44

(54) **VORRICHTUNG UND VERFAHREN ZUR VERMESSUNG VON HALBLEITERBASIERTEN LICHTQUELLEN**
DEVICE AND METHOD FOR MEASURING SEMICONDUCTOR-BASED LIGHT SOURCES
DISPOSITIF ET PROCÉDÉ DE MESURE DE SOURCES LUMINEUSES À SEMI-CONDUCTEUR

(30) Priorität: 27.11.2018 DE 102018130006
(43) Veröffentlichungstag der Anmeldung: 06.10.2021
(73) Patentinhaber: Instrument Systems GmbH, 81677 München (DE)
(72) Erfinder: HÄRING, Reto, 81369 München (DE); RIXNER, Christian, 83684 Tegernsee (DE); SCHEWE, Florian, 80639 München (DE); SADOWSKI, Siegbert, 87660 Irsee (DE); GAVRAILOV, Angel, 83059 Kolbermoor (DE); DOTZLER, Christian, 82065 Baierbrunn (DE); MANGSTL, Martin, 81737 München (DE)
(74) Vertreter: Schneiders & Behrendt Bochum
(86) Internationale Anmeldenummer: PCT/EP2019/082766
(87) Internationale Veröffentlichungsnummer: WO 2020/109399

(56) Entgegenhaltungen:
- US-A1- 2011 163 233
- US-A1- 2013 201 321
- US-A1- 2015 316 411
- US-A1- 2017 090 019
- BUREEV Y K ET AL: "A HIGH-FREQUENCY PHOTOMETER", MEASUREMENT TECHNIQUES, CONSULTANTS BUREAU. NEW YORK, US, vol. 35, no. 12, 1 December 1992 (1992-12-01), pages 1402 - 1404, XP000400082, ISSN: 0543-1972, DOI: 10.1007/BF00976883
- CORDER D A ET AL: "A novel method for energy measurement of short optical pulses", MEASUREMENT SCIENCE AND TECHNOLOGY, IOP, BRISTOL, GB, vol. 8, no. 9, 1 September 1997 (1997-09-01), pages 1034 - 1040, XP020064325, ISSN: 0957-0233, DOI: 10.1088/0957-0233/8/9/013

## Beschreibung

Die Erfindung betrifft ein Verfahren zur Vermessung einer Vielzahl von halbleiterbasierten Lichtquellen wie LEDs, OLEDs oder VCSEL, insbesondere vergleichsweise lichtschwachen Lichtquellen wie sogenannten Micro-LEDs. Des Weiteren betrifft die Erfindung eine Vorrichtung zur Durchführung des Verfahrens.

In der schnell fortschreitenden Entwicklung von halbleiterbasierten Lichtquellen werden die Abmessungen der einzelnen halbleiterbasierten Lichtquellen immer kleiner, insbesondere bei der Verwendung von Micro-LEDs für unterschiedlichste Displays, wobei gleichzeitig die Anzahl der für die jeweilige Anwendung benötigten halbleiterbasierten Lichtquellen stetig größer wird. Zudem wird mit den Abmessungen der halbleiterbasierten Lichtquellen auch die Lichtintensität der einzelnen halbleiterbasierten Lichtquellen geringer. In Produktionslinien von halbleiterbasierten Lichtquellen, wie beispielsweise LED-Displays, werden die Produktparameter mittels kurzer Lichtpulse zur Charakterisierung vermessen. Um die Messung der einzelnen halbleiterbasierten Lichtquellen möglichst effizient zu gestalten, ist es wünschenswert, jede einzelne halbleiterbasierte Lichtquelle sequentiell anzusteuern und einzeln zu vermessen.

Ein wichtiger Parameter bei der Vermessung ist die Konversionseffizienz und/oder der Wirkungsgrad, die üblicherweise über das Verhältnis von elektrischer Leistung zu optischer Leistung bzw. Wirkung bestimmt werden. Typischerweise wird für die Bestimmung der Konversionseffizienz mittels schneller Stromquellen für eine kurze Zeitspanne kleiner 100 µs, vorzugsweise kleiner 10 µs oder sogar kleiner 1 µs, ein konstanter Strom eingeprägt. Nach einer Stabilisierung von wenigen Millisekunden wird im quasi-stabilen Zustand die optische und elektrische Messung ausgelöst. Das Messgerät kann eine Photodiode zur Leistungsmessung, ein Photometer zur Messung des Lichtstroms oder ein Spektralradiometer sein, um auch farbmetrische und spezielle Eigenschaften vermessen zu können.

Hierbei stellt oftmals die thermische Belastung der halbleiterbasierten Lichtquellen bei der Messung ein Problem dar. Die Bauteile befinden sich in der Regel auf einem Wafer oder in einem kleinen Package, sodass die thermische Energie nur unzureichend abgeführt werden kann. Dadurch wird die Messdauer begrenzt bevor eine Überhitzung eintreten kann. Je kleiner der Prüfling ist, umso früher muss die Bestromung wieder ausgeschaltet werden.

Gleichzeitig ist es aber auch notwendig, in den kurzen Zeiträumen ein feststellbares und aussagekräftiges Signal zu erhalten. Es ist dabei wichtig, dass die Generierung des Lichtpulses und die jeweilige Detektion in höchstem Maße synchronisiert sind.

Bekannte Messvorrichtungen für einzelne optische Pulse (z.B. Laserverstärker) basieren meist auf pyroelektrischen Sensoren oder Thermopiles. Diese Systeme sind sehr träge und für LED-Anwendungen zu langsam. Bei einer herkömmlichen Messmethode mit einer Photodiode wird eine Leistungsmessung des Lichtpulses durch Abtastung durchgeführt. Die Abtastrate muss gerade bei kurzen Signalen sehr hoch gewählt werden, um ein genügend genaues Ergebnis zu erhalten. Gleichzeitig ist aber das Signal-/Rauschverhältnis durch die hohe Abtastrate sehr klein. Beim Einsatz eines Spektralradiometers ist es vorteilhaft, dass die gemessenen Signale auch spektral ausgewertet werden können. Nachteilig hierbei ist aber die relativ langsame Messung mit einem Spektralradiometer. Zudem ist die Synchronisierung zwischen Stromquelle und Spektrometer typischerweise mit einem Jitter zwischen den Messfenstern und den Pulsen behaftet, was zum Messfehler beiträgt. Die Messung ist insgesamt relativ unempfindlich und damit für lichtschwache halbleiterbasierten Lichtquellen kaum geeignet. Die kleinstmöglichen Messzeiten liegen aufgrund der Auslesezeiten der hier zum Einsatz kommenden CCD- oder CMOS-Sensoren bei einigen Millisekunden.

Eine Vorrichtung und ein Verfahren zur Vermessung einer Vielzahl von LED-Lichtquellen, mit einer Ulbrichtkugel, einem ersten Detektor, der Licht nach Wechselwirkung mit der Ulbrichtkugel misst und einem zweiten Detektor, der Licht an einer Austrittsöffnung ohne Wechselwirkung mit der Ulbrichtkugel misst, sind aus der US 2013/201321 A1 bekannt.

Es ist daher eine Aufgabe der vorliegenden Erfindung, ein Verfahren bereitzustellen das schneller, präziser und sensitiver arbeitet als die bekannten Verfahren, sodass die sequentielle Messung der Strahlungsenergie einer Vielzahl von vergleichsweise lichtschwachen halbleiterbasierten Lichtquellen innerhalb möglichst kurzer Zeit durchgeführt werden kann.

Die vorstehende Aufgabe wird durch ein Verfahren nach Anspruch 1 bzw. eine Vorrichtung nach Anspruch 11 gelöst. Vorteilhafte Ausführungsformen werden in den abhängigen Ansprüchen definiert. H

Hierzu werden die optischen Pulse mittels einer Photodiode in elektrische Ladungsträger umgewandelt werden, die elektrischen Ladungsträger mittels einer Integratorschaltung aufsummiert, die aufsummierten Ladungsträger mittels eines A/D-Wandlers in ein digitales Signal umgewandelt werden und das digitale Signal an die Auswerteeinheit weitergeleitet wird. Die Konversionseffizienz wird hierbei nicht wie üblicherweise aus dem Verhältnis von elektrischer Leistung zu optischer Leistung, sondern aus dem Verhältnis von elektrischer Energie zu optischer Energie ermittelt. Hierzu wird die von der Photodiode erzeugte Ladung mit der Integratorschaltung aufsummiert und mittels einer Kalibrierung in optische Energie umgerechnet. Die elektrische Leistung bzw. Energie wird aus dem Produkt aus der (relativ konstanten) Vorwärtsspannung an der halbleiterbasierten Lichtquelle und dem eingeprägten Strom bzw. der Ladung berechnet.

Eine Ausführung sieht vor, dass die optischen Pulse derart erzeugt werden, dass eine Vielzahl von Lichtquellen gleichzeitig oder nacheinander mittels einer gepulsten Stromquelle jeweils mit einem Strompuls beaufschlagt werden. Durch den Einsatz einer gepulsten Stromquelle ist eine präzise Ansteuerung und Synchronisierung besonders gut möglich.

Eine Weiterbildung sieht vor, dass mittels einer parallel zur Integratorschaltung geschalteten Komparatorschaltung eine Triggerung durch jeden Lichtpuls der halbleiterbasierten Lichtquelle erfolgt. Durch die Triggerung mittels der parallel geschalteten Komparatorschaltung ist eine sequentielle Ansteuerung mit einer Frequenz bis in den MHz-Bereich (> 100 kHz, vorzugsweise > 1 MHz) bei gleichzeitiger Detektion nur weniger Ladungsträger in den äußerst kurzen Messfenstern möglich. Im Vergleich zu den bekannten Methoden mit abtastenden Photodioden wird somit ein besseres Signal/Rausch-Verhältnis bei sehr hoher Sensitivität erreicht. Im Vergleich zu den bekannten Methoden mit einem Spektralradiometer werden Verfälschungen der Messergebnisse durch Jitter prinzipiell vermieden, es sind kürzere Messzeiten möglich und die benötigte Elektronik ist kostengünstiger und robuster.

Vorteilhaft ist es, wenn die Erzeugung und die Messung der optischen Pulse synchronisiert angesteuert werden. Durch diese Maßnahme ist die genaue Zuordnung der einzelnen Lichtquellen möglich, sodass die Zuordnung des Messergebnisses zu jeder einzelnen Lichtquelle jederzeit nachvollziehbar ist. Gleichzeitig wird durch die Synchronisation Jitter weiter ausgeschlossen.

Des Weiteren kann es vorteilhaft sein, wenn die Lichtquellen nicht einzeln, sondern in Gruppen von Lichtquellen sequentiell vermessen werden. Hierdurch wird die Vermessung weiter beschleunigt.

Die Erfindung sieht vor, dass eine Ulbricht-Kugel zur Erfassung des abgestrahlten Lichtpulses der Lichtquelle genutzt wird. Grundsätzlich wäre es möglich, aber sehr aufwändig, die Lichtquelle aus allen möglichen Richtungen mit einer Photodiode zu betrachten und den gesamten Lichtstrom als Summe der in die einzelnen Richtungen abgegebenen Anteile zu berechnen. Typischerweise ist aber nur der Lichtstrom selbst und nicht die Richtungsverteilung von Interesse. Durch die integrierende Wirkung der Ulbricht-Kugel wird die von der einzelnen Lichtquelle abgestrahlte ursprünglich ungleichförmig verteilte Lichtstärke aus allen Richtungen homogenisiert und erlaubt eine einfache Messung eines Signals das proportional zum Lichtstrom ist. Die integrierende Wirkung führt dazu, dass die am Ausgang gemessene Beleuchtungsstärke direkt proportional zum gesamten eingekoppelten Lichtstrom ist. Allerdings geht hierbei auch das zeitliche Profil eines eingestrahlten Lichtpulses verloren, weil in der Ulbricht-Kugel ein Lichtpuls in sehr viele einzelne Reflexe aufgespalten wird, die auf unterschiedlichen optischen Pfaden mit unterschiedlichen Weglängen bzw. mit unterschiedlichen Laufzeiten den Detektor erreichen. Das am Photodetektor gemessene Signal entspricht einer Faltung des ursprünglichen zeitlichen Pulsprofiles mit dem Verteilungsprofil der Laufzeiten. Die Pulse werden in der Ulbrichtkugel also zeitlich gedehnt, was bei sehr kurzen Pulsdauern bereits im ns-Bereich relevant wird.

Die Erfindung sieht vor, dass gegenüber der Eintrittsöffnung der Ulbricht-Kugel eine Austrittsöffnung eingefügt wird. Der Durchmesser der Austrittsöffnung wird dabei so gewählt, dass nur ein Teil des eingestrahlten Lichtpulses die Ulbricht-Kugel durch die Austrittsöffnung wieder verlassen kann, der übrige Anteil an der Innenwand reflektiert und wie oben beschrieben durch Mehrfachreflektion homogenisiert wird. Der Teil des Lichtpulses, der die Ulbricht-Kugel durch die Austrittsöffnung wieder verlässt, kann mit einem Detektor vermessen werden. Der Detektor kann sich direkt in der Austrittsöffnung aber auch hinter der Austrittsöffnung befinden. Zwischen der Austrittsöffnung und dem Detektor kann sich eine abbildende Optik befinden, mit welcher der die Ulbricht-Kugel verlassende Teil des Lichts auf den Detektor abgebildet wird. Das Licht kann aber auch mit einer Einkoppeloptik in eine lichtleitende Faser eingekoppelt und mit der lichtleitenden Faser zum Detektor weitergeleitet werden. Das Licht kann integrierend oder zeitaufgelöst gemessen werden. Somit ist es möglich, simultan den Lichtstrom und das zeitaufgelöste Profil des Pulses zu messen.

Zweckmäßig ist weiter, wenn zwischen Photodiode und Integratorschaltung ein Transimpedanzverstärker geschaltet wird. Durch den Transimpedanzverstärker wird der schwache, von der Photodiode erfasste Strom in eine Spannung proportional zum Lichtpuls verstärkt, sodass eine präzisere Auswertung möglich ist.

So schlägt die Erfindung zur Lösung der obigen Aufgabe eine Vorrichtung zur sequentiellen Vermessung einer Vielzahl optischer Pulse vor, mit einer gepulsten Stromquelle, einer Photodiode, einer Integratorschaltung, einem A/D-Wandler und einer Mess- und Steuereinheit, die zur Durchführung des beschriebenen Verfahrens eingerichtet ist.

Bei modernen Anwendungen von Halbleiterlichtquellen der oben erwähnten Art besteht die Anforderung, das Kurzpulsverhalten der Lichtquellen zu untersuchen. Dabei geht es darum, z.B. die Konversionseffizienz bei kurzer Pulsdauer im Bereich von weniger als einer µs oder sogar weniger als 100 ns oder 50 ns zu bestimmen. Parallel dazu sollen die (über viele Pulse) gemittelte Strahlungsleistung sowie auch die spektralen Eigenschaften der Lichtquellen bzw. der erzeugten Lichtpulse untersucht werden können.

Hierfür schlägt die Erfindung ein Verfahren vor, bei dem, unabhängig von der oben beschriebenen Art und Weise der Umwandlung der Lichtpulse in elektrische Ladungsträger per Photodiode und Integratorschaltung,
- die gepulste Lichtstrahlung über eine Eingangsöffnung in eine Ulbricht-Kugel eintritt,
- ein erster Teil der Lichtstrahlung, der die Ulbricht-Kugel nach Wechselwirkung mit derselben durch eine erste Ausgangsöffnung verlässt, mittels eines ersten Detektors vermessen wird und
- ein zweiter Teil der Lichtstrahlung, der die Ulbricht-Kugel ohne Wechselwirkung mit derselben durch eine zweite Ausgangsöffnung verlässt, mittels eines zweiten Detektors vermessen wird.

Der erste Teil der Lichtstrahlung hat die homogenisierende Wechselwirkung mit der Ulbricht-Kugel erfahren und kann zweckmäßig mittels des ersten Detektors im Hinblick auf mittlere, d.h. über mehrere optische Puls gemittelte Größen untersucht werden. Die Pulsform der kurzen optischen Pulse ändert sich aufgrund der Wechselwirkung mit der Ulbricht-Kugel, so dass das Kurzpulsverhalten der Lichtquellen mittels des ersten Detektors nicht untersucht werden kann, wohl aber radiometrische Größen, wie die mittlere Strahlungsleistung, oder photometrische Größen, wie der Lichtstrom. Der erste Detektor kann zweckmäßig ein Spektrometer oder ein Spektralradiometer sein, wie oben beschrieben.

Der zweite Detektor vermisst die Lichtstrahlung ohne Wechselwirkung mit der Ulbricht-Kugel. Ohne die Wechselwirkung mit der Ulbricht-Kugel bleibt der zeitliche Verlauf der optischen Pulse erhalten. Somit kann der zweite Detektor zweckmäßig dafür eingesetzt werden, den zeitlichen Verlauf der einzelnen optischen Pulse zu vermessen. Hierzu umfasst der zweite Detektor eine (schnelle) Photodiode, einen damit verbundenen A/D-Wandler und einen Digitalspeicher (z.B. Speicher-Oszilloskop), der den zeitlichen Verlauf der Spannung und/oder des Stroms der Photodiode aufzeichnet, und zwar vorzugsweise mit einer zeitlichen Auflösung von 10 ns oder weniger, vorzugsweise 1 ns oder weniger.

Um zu erreichen, dass der zweite Teil der Lichtstrahlung keine Wechselwirkung mit der Ulbricht-Kugel erfährt, ist zweckmäßig die zweite Ausgangsöffnung bezüglich des Mittelpunktes der Ulbrichtkugel gegenüber der Eingangsöffnung angeordnet. Auf diese Weise gelangt die durch die Eingangsöffnung in die Ulbricht-Kugel eingetretene Lichtstrahlung direkt, d.h. auf geradem Wege durch die zweite Ausgangsöffnung wieder aus der Ulbricht-Kugel heraus, ohne dass es zu Reflexionen an der Innenwand der Ulbricht-Kugel kommt.

Wie oben bereits beschrieben, können die optischen Pulse zweckmäßig erzeugt werden, indem eine Anordnung aus einer Vielzahl von Lichtquellen gleichzeitig oder nacheinander mittels einer gepulsten Stromquelle jeweils mit einem Strompuls beaufschlagt werden. Bei den Lichtquellen kann es sich um halbleiterbasierte Lichtquellen, wie LED, VCSEL oder OLED handeln, die zu Arrays bzw. Modulen zusammengefasst sind.

Bei kurzer Pulsdauer im Bereich von 100 ns oder darunter weicht der zeitliche Verlauf des einzelnen optischen Pulses von einem Rechteckpuls ab, selbst wenn der zugrunde liegende Strompuls rechteckförmig ist. Die Erfassung des zeitlichen Verlaufes des einzelnen Lichtpulses ist daher erforderlich, um die Konversionseffizienz im Kurzpulsregime der jeweiligen Lichtquellen präzise zu bestimmen. Zweckmäßig wird die Konversionseffizienz z.B. aus dem Verhältnis der durch den Strompuls eingeprägten elektrischen Energie und der mittels des zweiten Detektors gemessenen Energie des einzelnen Lichtpulses ermittelt.

Die Erfindung schlägt des Weiteren eine Vorrichtung zur sequentiellen Vermessung eine Vielzahl optischer Pulse vor, mit einer Ulbricht-Kugel, die gepulste Lichtstrahlung über eine Eingangsöffnung empfängt, wobei ein erster Teil der Lichtstrahlung, der die Ulbricht-Kugel nach Wechselwirkung mit derselben durch eine erste Ausgangsöffnung verlässt, auf einen hinter der ersten Ausgangsöffnung angeordneten ersten Detektor trifft, wobei ein zweiter Teil der Lichtstrahlung, der die Ulbricht-Kugel ohne Wechselwirkung mit derselben durch eine zweite Ausgangsöffnung, die bezüglich des Mittelpunktes der Ulbricht-Kugel gegenüber der Eintrittsöffnung angeordnet ist, verlässt, auf einen hinter der zweiten Ausgangsöffnung angeordneten zweiten Detektor trifft, und mit einer mit dem ersten und dem zweiten Detektor verbundenen Mess- und Steuereinheit. Die Mess- und Steuereinheit ist zweckmäßig dazu eingerichtet, das zuvor beschriebene Verfahren auszuführen.

Bei einer bevorzugten Ausgestaltung der erfindungsgemäßen Vorrichtung ist die erste und/oder die zweite Ausgangsöffnung über eine optische Faser mit dem ersten bzw. zweiten Detektor verbunden. Die Anbindung über optische Fasern hat den Vorteil, dass die Detektoren nicht unmittelbar an der Ulbricht-Kugel angeordnet sein müssen. Fehleranfällige Freistrahl-Abschnitte werden vermieden.

Wenigstens eine optische Faser, zum Beispiel diejenige optische Faser, die die erste Ausgangsöffnung mit dem ersten Detektor verbindet, kann bei einer bevorzugten Ausgestaltung einen Eingang und zwei Ausgänge aufweisen, wobei die durch die erste Ausgangsöffnung die Ulbricht-Kugel verlassende Lichtstrahlung in den Eingang eingekoppelt wird und die optische Faser durch beide Ausgänge verlässt, und zwar mit unterschiedlichen Intensitäten. Die Intensität der Lichtstrahlung wird, anders ausgedrückt, mit einem bestimmten, vorgegebenen Verhältnis auf die mindestens zwei Ausgänge aufgeteilt, zum Beispiel im Verhältnis 1:99 oder ein 10:90. Auf diese Weise kann der Dynamikbereich für die Vermessung der Lichtstrahlung erweitert werden. Bevorzugt ist jedem der Ausgänge der optischen Faser jeweils ein (erster oder zweiter) Detektor zugeordnet. Dabei vermisst einer der Detektoren die Lichtstrahlung bei hoher Intensität und der andere Detektor entsprechend bei niedrigerer Intensität.

Ausführungsbeispiele der Erfindung werden im Folgenden anhand der Zeichnungen dargestellt und erläutert. Es zeigen:
- Figur 1:: Schematisch ein Ersatzschaltbild einer Vorrichtung zur Messung einer Vielzahl von halbleiterbasierten Lichtquellen;
- Figur 2:: eine schematische Ansicht einer Vorrichtung mit nur einem Detektor;
- Figur 3:: eine schematische Ansicht einer Vorrichtung zur Messung einer Vielzahl von halbleiterbasierten Lichtquellen ohne eine Ulbricht-Kugel zu verwenden;
- Figur 4:: eine schematische Ansicht einer Vorrichtung in mit zwei Detektoren und unter Verwendung einer Ulbricht-Kugel;
- Figur 5:: eine schematische Ansicht einer erfindungsgemäßen Vorrichtung in einer ersten Ausführungsform;

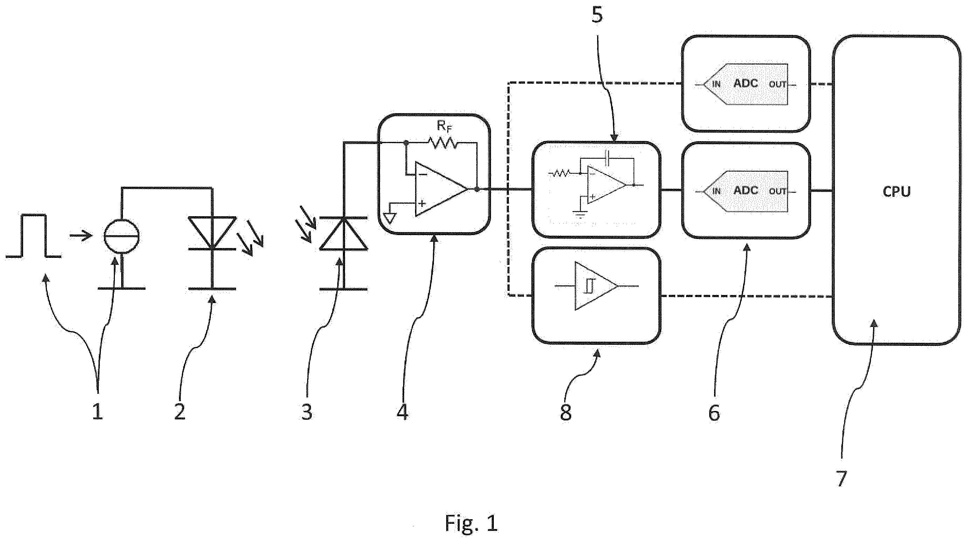

In Figur 1 ist eine gepulste Stromquelle mit dem Bezugszeichen 1 gekennzeichnet. Die gepulste Stromquelle 1 beaufschlagt eine LED 2 mit einem Strompuls. Die mit dem Strompuls beaufschlagte LED 2 strahlt einen Lichtpuls aus. Der Lichtpuls wird von einer Photodiode 3 erfasst und in einen zum Lichtpuls proportionalen elektrischen Strom umgewandelt. Der von der Photodiode 3 ausgesendete Strom wird über einen Transimpedanzverstärker 4 in eine zum Strom proportionale verstärkte Spannung gewandelt. Diese Spannung dient als Eingangsspannung einer Integratorschaltung 5. Die Integratorschaltung 5 summiert an ihrem Kondensator die Ladung auf. Die durch die Integratorschaltung 5 aufsummierte Ladung steht somit proportional im Verhältnis zur Energie des Lichtpulses. Das am Ausgang der Integratorschaltung 5 abgefasste analoge Signal wird über einen A/D-Wandler 6 in ein digitales Signal umgewandelt und an eine Mess- und Steuereinheit 7 weitergeleitet. Zudem ist parallel zur Integratorschaltung 5 eine Komparatorschaltung 8 vorgesehen. Die Komparatorschaltung 8 löst sowohl bei einer steigenden wie auch bei einer fallenden Pulsflanke bei einem jeweils einstellbaren Schwellwert ein Signal aus. Dieses Signal wird dann an die Mess- und Steuereinheit 7 weitergeleitet. Über den einstellbaren Schwellwert der Komparatorschaltung 8 lässt sich beispielsweise die Pulsdauer messen oder ein Trigger für die Synchronisierung mit einem anderen Messgerät oder der Stromquelle realisieren.

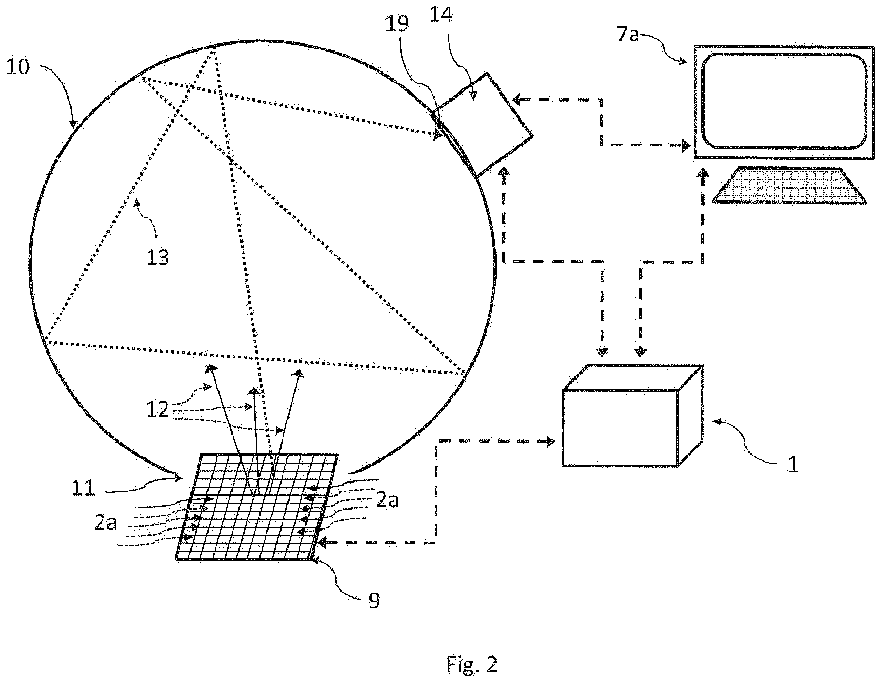

In Figur 2 ist schematisch der Aufbau für die Anwendung eines Verfahrens dargestellt. Ein Testobjekt mit einer Vielzahl von Micro-LEDs 2a, hier beispielsweise ein Micro-LED-Display 9 (oder ein Sub-Modul eines solchen Displays mit wenigstens noch einigen tausend Micro-LED), soll überprüft werden. Jede Micro-LED 2a des Mikro-LED-Displays 9 muss dabei einzeln vermessen werden. Das Micro-LED-Display 9 weist bis zu mehreren Millionen Micro-LEDs 2a auf. Für die Vermessung ist der folgende Messaufbau vorgesehen: Das Micro-LED-Display 9 wird in bzw. an der Eingangsöffnung 11 einer Ulbricht-Kugel 10 angeordnet. An der Ausgangsöffnung 19 der Ulbricht-Kugel 10 ist ein Detektormodul 14 vorgesehen.

Das Detektormodul 14 beinhaltet die in Figur 1 dargestellte Photodiode 3, den Transimpedanzverstärker 4, die Integratorschaltung 5, den A/D-Wandler 6. Die Mess- und Steuereinheit 7 aus Figur 1 ist hier durch einen PC 7a repräsentiert.

Das Micro-LED-Display 9, der PC 7a und das Detektormodul 14 sind jeweils mit der gepulsten Stromquelle 1 kommunikativ verbunden. Zudem kann über die gepulste Stromquelle 1 jede einzelne Micro-LED 2a des Micro-LED-Displays 9 adressiert angesprochen, also mit einem Strompuls beaufschlagt werden. Über die Kommunikationsschnittstellen kann der PC 7a folglich jede einzelne Micro-LED 2a ansteuern und darauf basierend das zugehörige Messergebnis zuordnen. Die sequentielle Vermessung der einzelnen Micro-LEDs 2a wird im MHz-Bereich durchgeführt. Daher ist die präzise Synchronisation von Stromquelle 1, Detektormodul 14 und dem PC 7a von hoher Bedeutung.

Wird nun eine einzelne Micro-LED 2a des Micro-LED-Displays 9 von der gepulsten Stromquelle 1 angesteuert, ist der abgegebene Lichtpuls einerseits eher lichtschwach und andererseits auch in verschiedene Raumrichtungen verteilt. Durch die integrierende Wirkung der Ulbricht-Kugel 10 wird der von der einzelnen Micro-LED 2a abgestrahlte, ursprünglich ungleichförmig verteilte, schwache Lichtpuls aus allen Richtungen gesammelt und ist in eine einfach messbare, mit dem gesuchten Lichtpuls in einem einfachen Zusammenhang stehende Beleuchtungsstärke umsetzbar. Die integrierende Wirkung führt dazu, dass die am Ausgang durch das Detektormodul 14 gemessene Beleuchtungsstärke direkt proportional zum gesamten eingekoppelten Lichtpuls ist. Das Detektormodul 14 führt nun die oben (s. Figur 1) beschriebenen Schritte durch und liefert das beschriebene digitale Messsignal an den PC 7a.

Anschließend wird über die Kommunikationsschnittstellen die nächste Micro-LED 2a mittels der gepulsten Stromquelle 1 mit einem Strom beaufschlagt. Die Frequenz der sequentiellen Vermessung reicht hierbei vom kHz- bis in den MHz-Bereich, somit können viele tausende bis einige Millionen Micro-LEDs 2a innerhalb kurzer Zeit vermessen werden.

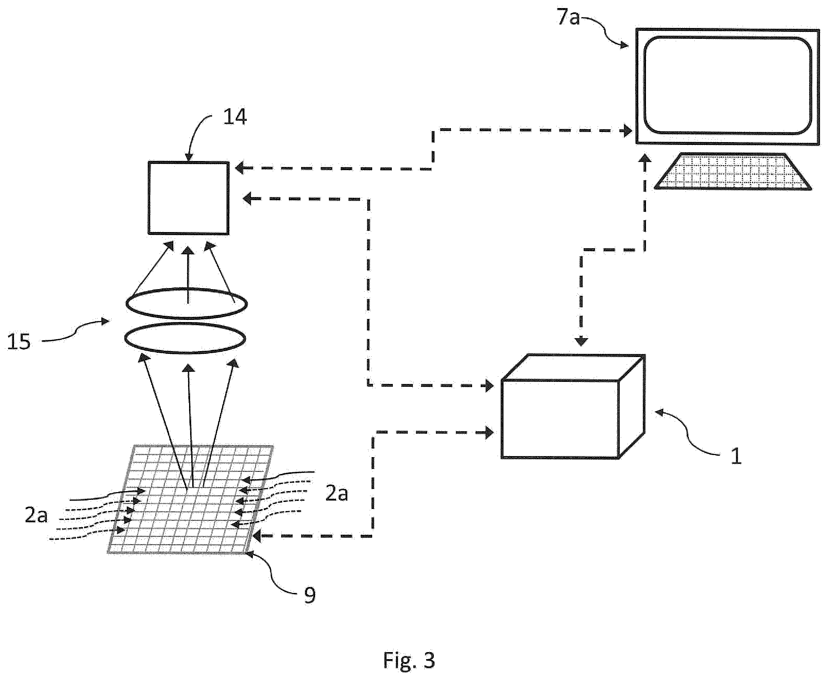

In Figur 3 ist schematisch der Aufbau für die Anwendung eines Verfahrens zur Messung einer Vielzahl von halbleiterbasierten Lichtquellen dargestellt. Der Aufbau ist sehr ähnlich zu dem Aufbau der Figur 2. Anstelle der in Figur 2 verwendeten Ulbricht-Kugel 10 wird in der in Figur 3 dargestellten zweiten Ausführungsform eine abbildende Optik 15 eingesetzt. Die abbildende Optik 15 erfüllt einen ähnlichen Zweck wie die Ulbricht-Kugel 10 in Figur 2. Hierbei wird der von der einzelnen Micro-LED 2a in verschiedene Raumrichtungen abgestrahlte Lichtpuls mittels der abbildenden Optik 15 gebündelt, sodass möglichst die durch das Detektormodul 11 gemessene Beleuchtungsstärke direkt proportional zum gesamten Lichtpuls der einzelnen Micro-LED 2a ist. Die folgenden Verfahrensschritte entsprechen denen bei der ersten Ausführungsform beschriebenen.

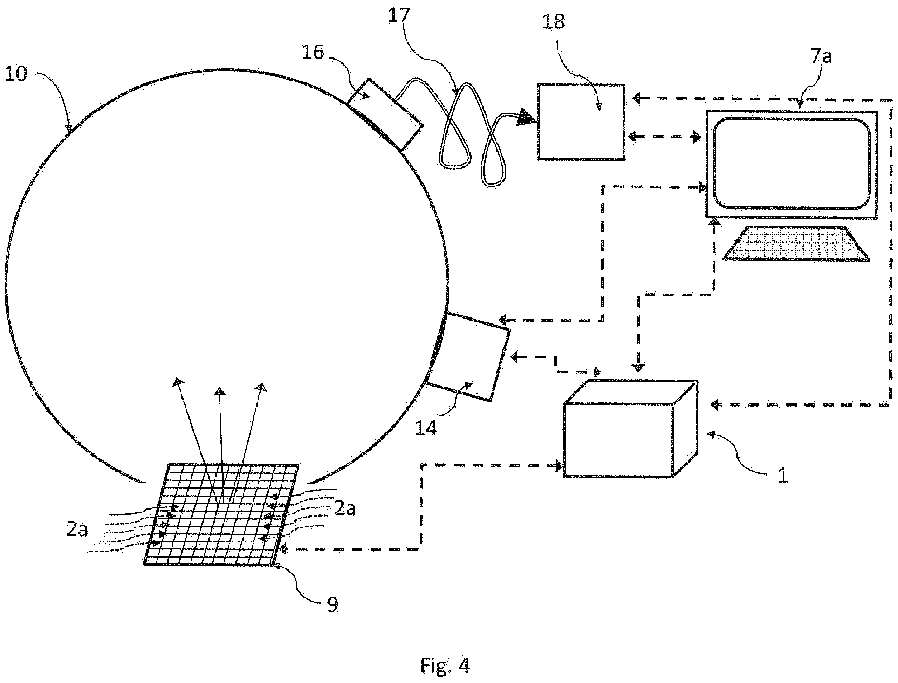

In Figur 4 ist schematisch der Aufbau für die Anwendung eines Verfahrens zur Messung einer Vielzahl von halbleiterbasierten Lichtquellen dargestellt. Dem Aufbau aus Figur 2 wird ein Spektrometer 18 hinzugefügt, so dass die Lichtpulse zusätzlich oder alleine mit dem Spektrometer 18 vermessen werden können. Die durch die Ulbricht-Kugel 10 homogenisierten Lichtpulse werden zunächst mit einer Faseroptik 16 in eine lichtleitende Faser 17 eingekoppelt und mit besagter lichtleitender Faser 17 in das Spektrometer 18 eingekoppelt, in welchem die Lichtpulse in ihre spektralen Komponenten zerlegt auf einem Zeilen- oder Array-Detektor abgebildet werden, mit diesem Detektor können die Spektren der Lichtpulse gemessen werden. Die Mess- und Auslesevorgänge des vorgenannten Detektors können beispielsweise über den PC 7a oder durch Trigger-Signale aus der Stromquelle 1 erfolgen, idealerweise werden die Mess- und Auslesevorgänge mit der Erzeugung der Lichtpulse synchronisiert. Mit diesem Aufbau können die Spektren der Lichtpulse, die mit einer einzelnen Lichtquelle 2a oder einer Gruppe von parallel angeregten Lichtquellen 2a erzeugt werden, vermessen werden. Des Weiteren kann auch eine Folge von Lichtpulsen spektral vermessen werden, welche mit aufeinander folgenden Strompulsen erzeugt werden, indem das Signal im Spektrometer 18 über mehrere Lichtpulse integriert oder gemittelt wird. Unter einem Spektralradiometer versteht man eine Kombination aus Spektrometer 18 und einer Einkoppeloptik (z.B. Faseroptik 16), für welches eine absolute Kalibrierung hinsichtlich Wellenlänge und spektraler Detektorempfindlichkeit vorliegt. Diese Kalibrierung kann z.B. auf dem PC 7a hinterlegt sein.

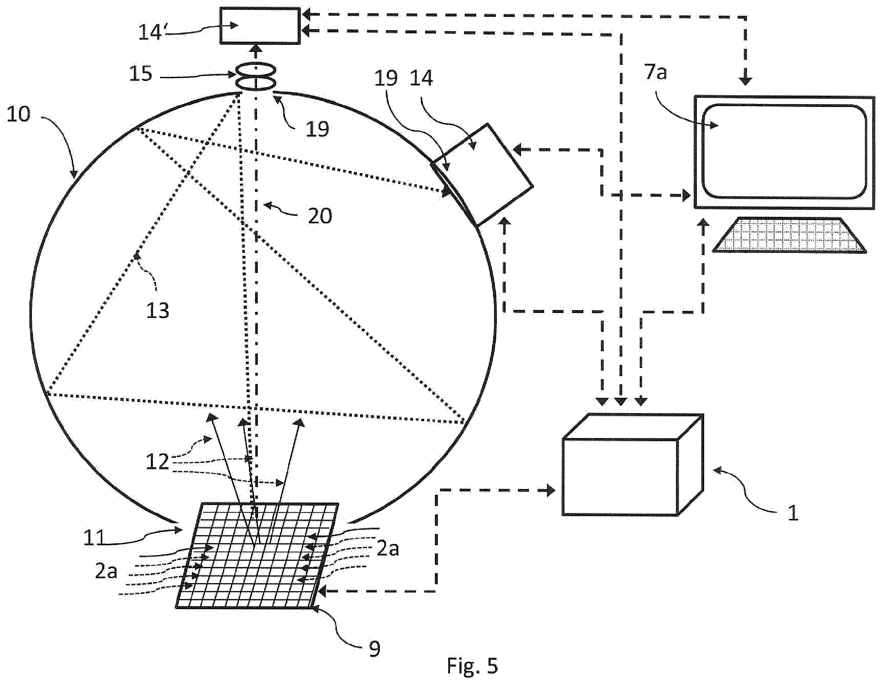

In Figur 5 ist schematisch der Aufbau für die Anwendung eines erfindungsgemäßen Verfahrens in einer ersten Ausführungsform dargestellt. Dem Aufbau aus Figur 2 wird eine Ausgangsöffnung 19 hinzugefügt, sodass ein Teil der Lichtpulse nach mehrfacher Reflektion 13 mit dem Detektor 14 gemessen werden kann, und ein Teil der Lichtpulse nach einem einfachen Durchgang 20 durch die Ulbricht-Kugel 10 ohne Mehrfachreflektion mit einem weiteren Detektor 14' vermessen werden kann. Bei dem Detektor 14' kann es sich um eine schnelle Photodiode handeln, z.B auf Basis von GalliumPhosphid, Silizium, IndiumGalliumArsenid oder Germanium. Der Detektor 14' ermöglicht eine zeitaufgelöste Messung der Pulse. Der Detektor 14' ist mit der Stromquelle 1 verbunden und synchronisiert. Die Lichtpulse 20 werden mit einer abbildenden Optik 15 auf dem Detektor 14' abgebildet.

In einer weiteren, nicht gezeigten Ausführungsform der Erfindung wird ein Teil der durch die Ulbricht-Kugel 10 homogenisierten Lichtpulse 13 mittels einer Faseroptik 16 in eine lichtleitende Faser 17 eingekoppelt und mit besagter lichtleitender Faser 17 in das Spektrometer 18 eingekoppelt, in welchem die Lichtpulse in ihre spektralen Komponenten zerlegt auf einem Zeilen- oder Array-Detektor abgebildet werden. Mit diesem Detektor werden die Spektren der Lichtpulse vermessen. Zweckmäßig weist das Spektrometer 18 eine Absolut-Kalibrierung auf, so dass damit relevante radiometrische, photometrische und farbmetrische Größen per Software aus den Spektraldaten errechnet werden können. Ein anderer Teil der Lichtpulse, der die Ulbricht-Kugel nach einem direkten Durchgang durch die Ulbricht-Kugel ohne Wechselwirkung mit der Innenwand der Ulbricht-Kugel verlässt, wird in eine weitere Faseroptik 16' eingekoppelt und über eine lichtleitende Faser 17' in einen Detektor 14' eingekoppelt. Bei dem Detektor 14' kann es sich um eine schnelle Photodiode handeln, z.B. auf Basis von GalliumPhosphid, Silizium, IndiumGalliumArsenid oder Germanium. Der Detektor 14' ermöglicht eine zeitaufgelöste Messung der Pulse, d.h. eine Messung des zeitlichen Verlaufs der einzelnen optischen Pulse (Lichtintensität als Funktion der Zeit). Der Detektor 14' ist mit der Stromquelle 1 verbunden und damit synchronisiert. Bei der lichtleitenden Faser 17' kann es sich um eine Faser mit einem Eingang und einem Ausgang handeln. Bei der lichtleitenden Faser 17' kann sich aber auch, wie dargestellt, um eine Faser mit einem Eingang und mehreren Ausgängen handeln, die das eingekoppelte Licht in gleichen oder unterschiedlichen Intensitätsverhältnissen in mehrere zweite Detektoren 14' einkoppeln.

### Bezugszeichenliste:

- 1: Stromquelle
- 2: LED
- 2a: Micro-LED
- 3: Photodiode
- 4: Transimpedanzverstärker
- 5: Integratorschaltung
- 6: A/D-Wandler
- 7: Mess- und Steuereinheit
- 7a: PC
- 8: Komparatorschaltung
- 9: Micro-LED-Display
- 10: Ulbricht-Kugel
- 11: Eingangsöffnung
- 12: Eingestrahltes Licht
- 13: Mehrfachreflektierter Strahl
- 14: Detektormodul
- 14': Detektormodul
- 15: abbildende Optik
- 16: Faseroptik
- 16': Faseroptik
- 17: Faser
- 17': Faser
- 18: Spektrometer
- 19: Ausgangsöffnung
- 20: Direkter Durchgang

## Patentansprüche

1. Verfahren zur sequentiellen Vermessung einer Vielzahl, von halbleiterbasierten Lichtquellen emittierter, optischer Pulse, wobei
- die gepulste Lichtstrahlung über eine Eingangsöffnung (11) in eine Ulbricht-Kugel (10) eintritt,
- ein erster Teil der Lichtstrahlung, der die Ulbricht-Kugel (10) nach Wechselwirkung mit derselben durch eine erste Ausgangsöffnung verlässt, mittels mindestens eines ersten Detektors (14, 18) vermessen wird und
- ein zweiter Teil der Lichtstrahlung, der die Ulbricht-Kugel (10) ohne Wechselwirkung mit derselben durch eine zweite Ausgangsöffnung (19) verlässt, mittels mindestens eines zweiten Detektors (14`) vermessen wird, der den zeitlichen Verlauf der einzelnen optischen Pulse misst, wobei der zweite Detektor (14') eine Photodiode, einen damit verbundenen A/D-Wandler und einen Digitalspeicher umfasst, der den zeitlichen Verlauf der Spannung und/oder des Stroms der Photodiode aufzeichnet.

2. Verfahren nach Anspruch 1, wobei die zweite Ausgangsöffnung (19) bezüglich des Mittelpunktes der Ulbrichtkugel (10) gegenüber der Eingangsöffnung (11) angeordnet ist.

3. Verfahren nach Anspruch 1 oder 2, wobei der erste Detektor (14, 18) eine radiometrische Größe, wie die Strahlungsleistung, und/oder eine photometrische Größe, wie den Lichtstrom, misst.

4. Verfahren nach Anspruch 3, wobei der erste Detektor (14, 18) ein Spektrometer, bevorzugt ein Spektralradiometer ist.

5. Verfahren nach einem der vorgenannten Ansprüche, wobei der zweite Detektor (14') den zeitlichen Verlauf mit einer zeitlichen Auflösung von 10 ns oder weniger, vorzugsweise 1 ns oder weniger erfasst.

6. Verfahren nach einem der vorgenannten Ansprüche , wobei die optischen Pulse erzeugt werden, indem eine Anordnung aus einer Vielzahl von Lichtquellen (2a) gleichzeitig oder nacheinander mittels einer gepulsten Stromquelle (1) jeweils mit einem Strompuls beaufschlagt werden.

7. Verfahren nach einem der vorgenannten Ansprüche, **dadurch gekennzeichnet, dass** es sich bei den Lichtquellen um halbleiterbasierte Lichtquellen, wie LED, VCSEL oder OLED handelt.

8. Verfahren nach einem der vorgenannten Ansprüche, **dadurch gekennzeichnet, dass** die Konversionseffizienz der Lichtquellen (2a) aus dem Verhältnis der durch den Strompuls eingeprägten elektrischen Energie und der mittels des zweiten Detektors (14') gemessenen Energie des einzelnen Lichtpulses ermittelt wird.

9. Verfahren nach einem der vorgenannten Ansprüche, **dadurch gekennzeichnet, dass** die Frequenz der Strompulse, mit denen die Lichtquellen nacheinander beaufschlagt werden, mehr als 100 kHz, vorzugsweise mehr als 1 MHz beträgt.

10. Verfahren nach einem der vorgenannten Ansprüche, wobei die Dauer des einzelnen Lichtpulses weniger als 1µs, vorzugsweise weniger als 100 ns beträgt.

11. Vorrichtung zur sequentiellen Vermessung einer Vielzahl, von halbleiterbasierten Lichtquellen emittierter, optischer Pulse, mit einer gepulsten Stromquelle zur Beaufschlagung der Lichtquellen mit einem Strompuls, einer Ulbricht-Kugel (10), die die gepulste Lichtstrahlung über eine Eingangsöffnung (11) empfängt, wobei ein erster Teil der Lichtstrahlung, der die Ulbricht-Kugel (10) nach Wechselwirkung mit derselben durch eine erste Ausgangsöffnung verlässt, auf einen hinter der ersten Ausgangsöffnung angeordneten ersten Detektor (14, 18) trifft, wobei ein zweiter Teil der Lichtstrahlung, der die Ulbricht-Kugel (10) ohne Wechselwirkung mit derselben durch eine zweite Ausgangsöffnung (19), die gegenüber der Eintrittsöffnung (11) angeordnet ist, verlässt, auf einen hinter der zweiten Ausgangsöffnung (19) angeordneten zweiten Detektor (14') trifft, und mit einer mit dem ersten und dem zweiten Detektor verbundenen Mess- und Steuereinheit (7), wobei der zweite Detektor (14') eine Photodiode, einen damit verbundenen A/D-Wandler und einen Digitalspeicher umfasst, der den zeitlichen Verlauf der Spannung und/oder des Stroms der Photodiode aufzeichnet..

12. Vorrichtung nach Anspruch 11, wobei die Mess- und Steuereinheit (7) zur Durchführung des Verfahrens nach einem der Ansprüche 16 bis 28 eingerichtet ist.

13. Vorrichtung nach Anspruch 11 oder 12, wobei die erste und/oder die zweite Ausgangsöffnung (19) über eine optische Faser (17, 17') mit dem ersten bzw. zweiten Detektor (14, 14`, 18) verbunden ist.

14. Vorrichtung nach Anspruch 13 wobei die optische Faser (17, 17') einen Eingang und mindestens zwei Ausgänge aufweist, wobei die Lichtstrahlung aus den Ausgängen mit unterschiedlichen Intensitäten austritt.

15. Vorrichtung nach Anspruch 14 wobei jedem Ausgang der optischen Faser (17, 17') ein erster bzw. zweiter Detektor (14, 14`, 18) zugeordnet ist.

## Claims

1. Method for the sequential measurement of a plurality of optical pulses emitted by semiconductor-based light sources, whereby
- the pulsed light radiation enters an Ulbricht-sphere (10) via an inlet opening (11),
- a first portion of the light radiation that exits the Ulbricht sphere (10) following interaction with the same through a first outlet opening is measured by means of at least one first detector (14, 18) and
- a second portion of the light radiation, which exits the Ulbricht sphere (10) without interacting with it through a second outlet opening, is measured by means of at least a second detector (14'), which measures the temporal progression of the individual optical pulses, the second detector (14') comprising a photodiode, an A/D converter and a digital memory, which records the temporal progression of the voltage and/or current of the photodiode.

2. Method according to claim 1, wherein the second outlet opening (19) is arranged opposite the inlet opening (11) with reference to the central point of the Ulbricht sphere (10).

3. Method according to claim 1 or 2, wherein the first detector (14, 18) measures a radiometric parameter, such as the radiation power, and/or a photometric parameter, such as the luminous flux.

4. Method according to claim 3, wherein the first detector (14, 18) is a spectrometer, preferably a spectroradiometer.

5. Method according to any one of the preceding claims, wherein the second detector (14') records the temporal progression with a temporal resolution of 10 ns or less, preferably 1 ns or less.

6. Method according to any one of the preceding claims, wherein the optical pulses are generated by a current pulse being applied respectively to an arrangement of a plurality of light sources (2a) simultaneously or consecutively by means of a pulsed current source (1).

7. Method according to any one of the preceding claims, **characterized in that** the light sources are semiconductor-based light sources such as LEDs, VCSELs or OLEDs.

8. Method according to any one of the preceding claims, **characterized in that** the conversion efficiency of the light sources (2a) is determined from the ratio of the electric energy impressed by the current pulse and the energy of the individual light pulse measured by means of the second detector (14').

9. Method according to any one of the preceding claims, **characterized in that** the frequency of the current pulses which are applied consecutively to the light sources is more than 100 kHz, preferably more than 1 MHz.

10. Method according to any one of the preceding claims, wherein the duration of the individual light pulse is less than 1 µs, preferably less than 100 ns.

11. Device for the sequential measurement of a plurality of optical pulses emitted by semiconductor-based light sources, having a pulsed current source for applying a current pulse to the light sources, an Ulbricht sphere (10), which receives pulsed light radiation via an inlet opening (11), wherein a first portion of the light radiation, which exits the Ulbricht sphere (10) following interaction with the same through a first outlet opening, encounters a first detector (14, 18) arranged behind the first outlet opening, wherein a second portion of the light radiation, which exits the Ulbricht sphere (10) without interaction with the same through a second outlet opening (19) arranged opposite the inlet opening (11), encounters a second detector (14') arranged behind the second outlet opening (19), and with a measurement and control unit (7) connected to the first and the second detector, wherein the second detector (14') comprises a photodiode, an A/D converter connected thereto and a digital memory, which records the temporal progression of the voltage and/or current of the photodiode.

12. Device according to claim 11, wherein the measurement and control unit (7) is configured to execute the method according to any one of claims 16 to 28.

13. Device according to claim 11 or 12, wherein the first and/or the second outlet opening (19) is connected via an optical fiber (17, 17') to the first or second detector (14, 14', 18), respectively.

14. Device according to claim 13, wherein the optical fiber (17, 17') comprises an input and at least two outputs, wherein the light radiation exits the outputs at different intensities.

15. Device according to claim 14, wherein each output of the optical fiber (17, 17') is assigned a first or second detector (14, 14', 18).

## Revendications

1. Procédé de mesure séquentielle d'une pluralité d'impulsions optiques émises par des sources de lumière à base de semi-conducteurs, dans lequel
- le rayonnement lumineux pulsé entre dans une sphère d'Ulbricht (10) par un ouverture d'entrée (11),
- une première partie du rayonnement lumineux, qui quitte la sphère d'Ulbricht (10) après avoir interagi avec elle par une première ouverture de sortie, est mesurée au moyen d'au moins un premier détecteur (14, 18), et
- une deuxième partie du rayonnement lumineux, qui quitte la sphère d'Ulbricht (10) sans interagir avec celle-ci par une deuxième ouverture de sortie (19), est mesurée au moyen d'au moins un deuxième détecteur (14') qui mesure l'évolution dans le temps des impulsions optiques individuelles, le deuxième détecteur (14') comprenant une photodiode, un convertisseur A/D relié à celle-ci et une mémoire numérique qui enregistre l'évolution dans le temps de la tension et/ou du courant de la photodiode.

2. Procédé selon la revendication 1, dans lequel la deuxième ouverture de sortie (19) est située à l'opposé de l'ouverture d'entrée (11) par rapport au centre de la sphère d'Ulbricht (10).

3. Procédé selon la revendication 1 ou 2, dans lequel le premier détecteur (14, 18) mesure une quantité radiométrique, telle que la puissance de rayonnement, et/ou une quantité photométrique, telle que le flux lumineux.

4. Procédé selon la revendication 3, dans lequel le premier détecteur (14, 18) est un spectromètre, de préférence un spectroradiomètre.

5. Procédé selon l'une des revendications précédentes, dans lequel le deuxième détecteur (14') détecte l'évolution temporelle avec une résolution temporelle de 10 ns ou moins, de préférence de 1 ns ou moins.

6. Procédé selon l'une des revendications précédentes, dans lequel les impulsions optiques sont générées en appliquant une impulsion de courant à une agencement d'une pluralité de sources de lumière (2a) simultanément ou successivement au moyen d'une source de courant pulsé (1).

7. Procédé selon l'une des revendications précédentes, **caractérisé en ce que**, **en ce que** les sources de lumière sont des sources de lumière à base de semi-conducteurs, telles que des LED, des VCSEL ou des OLEO.

8. Procédé selon l'une des revendications précédentes, **caractérisé en ce que** l'efficacité de conversion des sources lumineuses (2a) est déterminée à partir du rapport entre l'énergie électrique imposée par l'impulsion de courant et l'énergie de l'impulsion lumineuse individuelle mesurée au moyen du deuxième détecteur (14').

9. Procédé selon l'une des revendications précédentes, **caractérisé en ce que** la fréquence des impulsions de courant appliquées successivement aux sources lumineuses est supérieure à 100 kHz, de préférence supérieure à 1 MHz.

10. Procédé selon l'une des revendications précédentes, dans lequel la durée de chaque impulsion de lumière est inférieure à 1 µs, de préférence inférieure à 100 ns.

11. Dispositif pour mesurer séquentiellement une pluralité d'impulsions optiques émises par des sources lumineuses à base de semi-conducteurs, avec une source de courant pulsé pour appliquer une impulsion de courant aux sources lumineuses, une sphère d'Ulbricht (10) recevant le rayonnement lumineux pulsé par l'intermédiaire d'une ouverture d'entrée (11), dans lequel une première partie du rayonnement lumineux, qui quitte la sphère d'Ulbricht (10) après avoir interagi avec celle-ci à travers une première ouverture de sortie, rencontre un premier détecteur (14, 18) disposé derrière la première ouverture de sortie, dans lequel une deuxième partie du rayonnement lumineux, qui quitte la sphère d'Ulbricht (10) sans interagir avec celle-ci, à travers une deuxième ouverture de sortie, située à l'opposé de l'ouverture d'entrée (11), rencontre un deuxième détecteur (14') situé derrière la deuxième ouverture de sortie (19), et avec une unité de mesure et de commande (7) reliée aux premier et deuxième détecteurs, le deuxième détecteur (14') comprenant une photodiode, un convertisseur A/D relié à celle-ci et une mémoire numérique qui enregistre la variation dans le temps de la tension et/ou du courant de la photodiode.

12. Dispositif selon la revendication 11, dans lequel l'unité de mesure et de commande (7) est agencée pour mettre en oeuvre le procédé selon l'une quelconque des revendications 16 à 28.

13. Dispositif selon la revendication 11 ou 12, dans lequel le premier et/ou la deuxième ouverture de sortie (19) sont reliés respectivement au premier et au deuxième détecteur (14, 14', 18) par une fibre optique (17, 17').

14. Dispositif selon la revendication 13, dans lequel la fibre optique (17, 17') comprend une entrée et au moins deux sorties, le rayonnement lumineux sortant des sorties avec des intensités différentes.

15. Dispositif selon la revendication 14, dans lequel un premier et un deuxième détecteur (14, 14', 18) sont respectivement associés à chaque sortie de la fibre optique (17, 17').
